# EUROPEAN PATENT APPLICATION

(11) **EP 2 354 378 A1**
(43) Date of publication of application: **10.08.2011**
(21) Application number: 10152323.1
(22) Date of filing: 01.02.2010
(51) Int. Cl.: E04H 5/02, H05K 7/20, G06F 1/20, E04H 1/12

(54) **Modular datacenter element and modular datacenter cooling element**

(71) Applicant: Dataxenter IP B.V., 2031 BE Haarlem (NL); KGG Dataxenter Holding B.V., 1812 PW Alkmaar (NL)
(72) Inventor: HASPERS, Rolph, 2031 BE Haarlem (NL); REUS, Nico, 1713 GK Obdam (NL)
(74) Representative: Groot Koerkamp, Jasper Henri

(57) **Abstract**

Modular datacenter element (100), comprising: a modular space defined by at least a bottom panel (120); and a front wall (110) having substantially the same length as the bottom panel (120), placed substantially vertically on the bottom panel (120); further comprising a plurality of racks (112) for holding equipment, the racks (112) being aligned in an opening in the front wall (110) along the length of the bottom panel (120); wherein a first side of the aligned plurality of racks (112) is spaced away from a first edge (122) along the length of the bottom panel (120) at a distance substantially smaller than the width of the bottom panel (120), thus creating a ledge bottom part (126) between the first edge (122) of the bottom panel (120) and the plurality of racks (112). By creating a datacenter comprising multiple modular datacenter elements (100), a datacenter with efficient inspection possibilities and efficient air handling is created.

## Description

### FIELD OF THE INVENTION

The invention relates to modular datacenters and elements for building such modular datacenter.

### BACKGROUND OF THE INVENTION

Modular and in particular mobile datacenters are used for providing data processing and data communication on a temporary basis and are implemented as almost fully self-supporting units. Such datacenters are particularly well suited for more extreme environments, like in regions with very cold, very hot and/or very humid climates.

United States Patent Application Publication US2009/0229194 A1 discloses a portable data center comprising one or more modular containers, the containers comprising expandable and retractable side walls, ceiling panels and floor panels and racks configured to securely hold equipment. The containers further comprise insulation and numerous security measures for protecting equipment located in the container. More in particular, the container is a steel ISO container as used for transport of cargo on ships, trains and lorries.

Steel ISO containers are very heavy by themselves, making them not very easy to transport. The fact that the containers are made of steel means that these containers have a low fire resistance.

Furthermore, combining ISO containers to a larger datacenter requires walls to be taken out and therefore significant customization of the containers. This is expensive, whereas such combination will still never have the look-and feel of a traditional datacenter, with hallways, reception, meet-me-rooms, and the like. Contrary to that, ISO containers, due to the metal nature and their nature in general, will never become a permanent building, as defined by regulations. In addition to that, self-supporting datacenter containers may be efficient for temporary use on a small scale, when using for example only one data center, but when combining multiple containers, it may be more efficient to provide equipment auxiliary to data processing and data communication like cooling in another unit than the portable datacenter container holding the equipment as well.

Also, standard ISO containers have are relatively small inner space, requiring racks to be placed on a slidable mount for properly handling equipment. Besides that, separation of cold air from air conditioning units and hot air from equipment is not efficiently handled in the portable data center disclosed by US2009/0229194 A1.

### OBJECT AND SUMMARY OF THE INVENTION

It is an objective of the invention to provide a modular datacenter element that is easier to handle and to operate.

In a first aspect, the invention provides a modular datacenter element, comprising: a modular space defined by at least a bottom panel; and a front wall having substantially the same length as the bottom panel, placed substantially vertically on the bottom panel; a plurality of racks for holding equipment, the racks being aligned in an opening in the front wall along the length of the bottom panel; wherein a first side of the aligned plurality of racks is spaced away from a first edge along the length of the bottom panel at a distance substantially smaller than the width of the bottom panel, thus creating a ledge bottom part between the first edge of the bottom panel and the plurality of racks.

With the one side of the racks spaced away from the first edge, a ledge is created. This ledge provides a walkway along the racks so equipment can be inspected. With first modular datacenter element placed against a second modular datacenter element arranged such that the front walls of two modular datacenter elements are substantially parallel to one another and facing each other with the ledges meeting each other, a corridor is created for inspecting equipment in racks of both modular datacenter elements. An advantage of this is that the ledge is not required to be very broad, as in an advantageous case a corridor will be formed by two ledges.

In addition, the front wall provides a barrier between a first space near a first side of the racks and a second space near a second side of the racks. This barrier thus is able to create a boundary between hot air on one side of the racks and cold air on another side of the racks.

In an embodiment of the modular datacenter element according to the invention, a second side of the aligned plurality of racks opposite to the first side of the racks is spaced away from a second edge of the bottom panel opposite to the first edge of the bottom panel at a pre-determined distance determined by a dimension of the racks along the width of the bottom panel.

An advantage of this embodiment is that within the space of the modular datacenter element, enough room is provided to remove equipment from the racks at the second side of the racks.

An embodiment of the modular datacenter element according to the invention comprises at least two support elements near or at opposite ends of the second edge of the bottom panel; and a top frame located at the upper side of the modular datacenter element, the top frame comprising four side elements, each element being parallel to an edge of the bottom panel, the top frame being support by at least the two support elements.

An advantage of this embodiment is that eventual walls of the modular datacenter element do not need to be robust enough to support the load of a module placed on top of the modular datacenter element. Such walls can even be omitted to enable spaces of multiple modular datacenter elements to be shared.

An embodiment of the modular datacenter element according to the invention further comprises a door in the front wall.

If the modular datacenter element is fully closed by a front wall, sidewalls and a rear wall, such door provides access to a side of the racks other than the side of the racks directly adjacent to the ledge. Such door may be subject to access restrictions.

In a second aspect, the invention provides a modular datacenter cooling element, comprising a cooling unit; a further bottom panel having substantially the same dimensions as the bottom panel of the modular datacenter element according to claim 1; a wall holding the cooling unit for separating hot air to be cooled from cool air flowing out of the cooling unit; Wherein the modular datacenter cooling element is arranged to be placed either on top of or below the modular datacenter element according to claim 1, whereby when the modular datacenter cooling element is placed on top of or below the modular datacenter element, the front wall of the modular datacenter cooling element forms together with the front wall of the modular datacenter element a contiguous substantially vertical barrier in the ensemble of the modular datacenter cooling element and the modular datacenter element; the cooling unit is arranged for generating and cooling an airflow flowing from a first side of the cooling unit to a first side of the front wall of the modular datacenter element, through at least a part of the plurality of racks towards a second side of the front wall and to a second side of the cooling unit; and the further bottom panel is arranged for passing trough the airflow.

An advantage of this modular datacenter air handling element, in particular when used in conjunction with the modular datacenter element according to the invention, is that cold air exhausted by the air handling unit is separated from hot air coming out of equipment located in the racks.

Furthermore, by providing a separate modular datacenter air handling element, more space is available in the modular datacenter element for inspecting and handling equipment.

An additional advantage is that the maintenance layer is separate from the IT layer, which enhances security. Maintenance personnel do not need to enter the IT modules, which is a high-security zone.

In an embodiment of the modular datacenter air handling element according to the invention, the air handling unit comprises an evaporative cooling unit.

Advantages of evaporative cooling units are that evaporative cooling is less costly and more reliable than closed-loop vapor-compression cooling. In particular, evaporative cooling consumes less energy. Evaporative cooling is currently not being used in datacenters, as liquids and in particular water is avoided as much as possible to prevent damage to the delicate equipment located in data centers, in particular when such liquids or water is not used in a closed loop. On the other hand, at least slightly humidified air is advantageous to prevent damage from electrostatic discharges. In addition, with indirect evaporative cooling, the liquid can be kept outside the datacenter.

In a third aspect, the invention provides a system comprising at least two modular datacenter elements according to claim 1, arranged such that the front walls of two modular datacenter elements are substantially parallel to one another and facing each other with the ledges meeting each other; and at least two modular datacenter air handling elements according to claim 9, each modular datacenter cooling element placed on top of a modular datacenter element, such the front wall of the modular datacenter air handling element forms together with the front wall of the modular datacenter element a contiguous substantially vertical barrier in the ensemble of the modular datacenter air handling element and the modular datacenter element.

This system combines the advantages of the modular datacenter element according to the invention with the advantages of the modular datacenter air handling element according to the invention. Hot air is separated from cold air, creating a cool zone between both front walls and two hot zones on the other sides of the front walls - or the other way around. In addition, redundancy is provided in air handling. With the cool zone provided between the front walls of the system, the cool air in the cool zone can be provided by only one air handling unit instead of two.

### BRIEF DESCRIPTION OF THE DRAWINGS

The invention and embodiments thereof will now be further elucidated by means of figures. In the figures,
- Figure 1 A: shows a first view of an embodiment of the modular datacenter according to the invention;
- Figure 1 B: shows a second view of an embodiment of the modular datacenter according to the invention;
- Figure 2: shows another embodiment of the modular datacenter according to the invention;
- Figure 3 A: shows a first data rack configuration;
- Figure 3 B: shows a second data rack configuration;
- Figure 4: shows an embodiment of the modular datacenter cooling element according to the invention;
- Figure 5: shows how an embodiment of the modular datacenter cooling element according to the invention can be placed on top of an embodiment of the modular datacenter according to the invention
- Figure 6 A: shows a datacenter an embodiment of the system according to the invention;
- Figure 6 B: shows another datacenter an embodiment of the system according to the invention;
- Figure 6 C: shows a further datacenter an embodiment of the system according to the invention;
- Figure 6 D: shows a larger datacenter an embodiment of the system according to the invention;
- Figure 7: shows an airflow configuration in an embodiment of the system according to the invention;
- Figure 8: shows another airflow configuration in an embodiment of the system according to the invention;
- Figure 9: shows an example of direct evaporative cooling unit for use with the modular datacenter cooling element according to the invention and/or embodiments thereof; and
- Figure 10: shows an example of indirect evaporative cooling unit for use with the modular datacenter cooling element according to the invention and/or embodiments thereof

### DESCRIPTION OF PREFERRED EMBODIMENTS

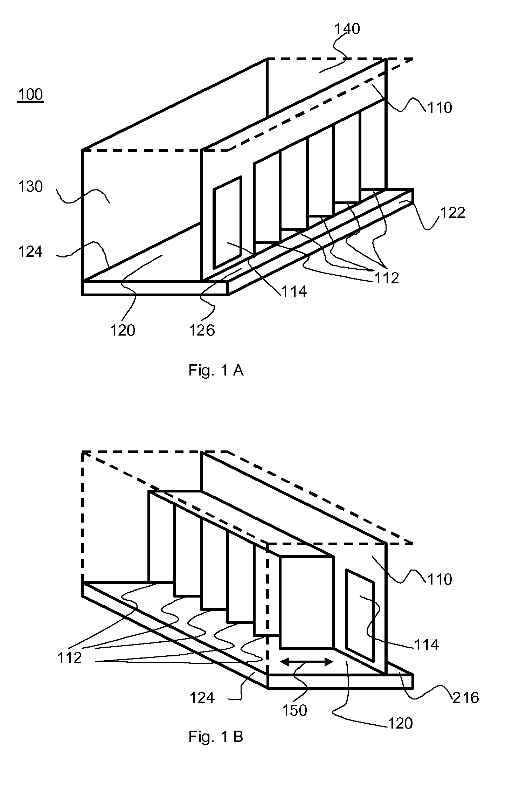

Figure 1A shows a schematic view of a modular datacenter housing unit 100 as an embodiment of the modular datacenter element according to the invention. The modular datacenter housing unit 100 comprises a front wall 110, a bottom panel 120 and a rear wall 130. The front wall 110 is placed away from a first edge 122 of the bottom panel, thus providing a ledge 126 between the front wall 110 and the first edge 122. The width of the edge is substantially smaller than the total width of the bottom panel 120. The rear wall 130 has substantially the same dimensions as the front wall 110 and is placed substantially parallel to the front wall 110 at or close to a second edge 124 of the bottom panel, which second edge 124 is opposite to the first edge 122.

The actual dimensions of the modular datacenter housing unit 100 are substantially defined by the size of the height and width of the front wall 110 and the depth and width of the bottom panel 120. Because the rear wall 130 has about the same dimensions as the front wall 110 and is placed substantially parallel to the front wall 110 at or close to a second edge 124 of the bottom panel, the dimensions of the rear wall 130 do in this case not provide additional information on the definition of the dimensions of the modular datacenter housing unit 100. Also an optional top panel 140 would not substantially change the dimensions of the modular datacenter housing unit 100, other than possibly by a certain thickness of the top panel 140. The top panel 140 is drawn with a dotted line for reasons of clarity.

The front wall 110 comprises a large opening for housing a plurality of racks 112 for holding data equipment like internet servers, storage servers and similar equipment. In addition, the front wall 110 is provided with a door 114 for accessing the space between the front wall 110 and the rear wall 130 for example to service the equipment located in the racks 112. If other means are provided for accessing this space, the door 114 may be omitted and/or replaced with additional racks for holding equipment. The racks are placed away from the first edge 122 of the bottom panel 120 at the same distance as the front wall 110 is in this embodiment placed away from the first edge 122.

Figure 1B shows another schematic view of the modular datacenter housing unit 100, providing a better view to the plurality of racks 112. The racks 112 extend from the front wall 110 to the rear wall. The racks also extend from the ledge 126 away towards the second edge 127 of the bottom panel 120 Preferably, the racks are standard 19 inch racks (482.6 mm wide). The depth of the racks may depend on the use case. Common sizes are 31.5 inches (800 mm) or 39.4 inches (1,000 mm).

The depth of the racks 112 determines how far the racks 112 extend from the ledge 126 and from the front wall 110. Preferably, the distance between the ledge 126 and the second edge 124 is at least twice as much as the depth of the racks 112. In other words, the space between the aligned plurality of racks 112 and the second edge 124 is preferably at least the same as the dimension of the racks measured along the width of the bottom panel 120 which dimension is indicated by an arrow 150. This is to enable server modules to be inserted into and taken out of the racks 112 without having to move the racks and/or without being hindered by the rear wall 130.

If the room between the end of a rack 112 and the rear wall 130 would be less than the depth of the rack 112 and a full-depth piece of equipment would have to be taken out, the equipment would touch the rear wall 130 before being fully removed from the rack 112. In a worst case, this would mean that the equipment cannot be properly removed from or inserted in the rack 112, unless the rear wall 130 would be removed and/or the rack 112 would be moved in the direction of the front wall 110.

The dimensions of the datacenter housing unit 100 are preferably about 3 meters wide, 3 meters high and 6 meters long. A first advantage is that the largest width of road cargo allowed to be transported on the road in for example the Netherlands is 3 meters, for undividable load. Furthermore, these sizes are similar to commonly available portable housing modules like the PK202 of Portakabin®. With respect to further implementation, the preferred width of the ledge 126 is about 0,5 meters, the depth of the racks 39.4 inches (1,000 mm). This would result in a distance between the aligned racks 112 and the second edge 124 that is longer than the dimension indicated by the arrow 150. In a preferred embodiment, the datacenter housing unit 100 comprises eight racks 112.

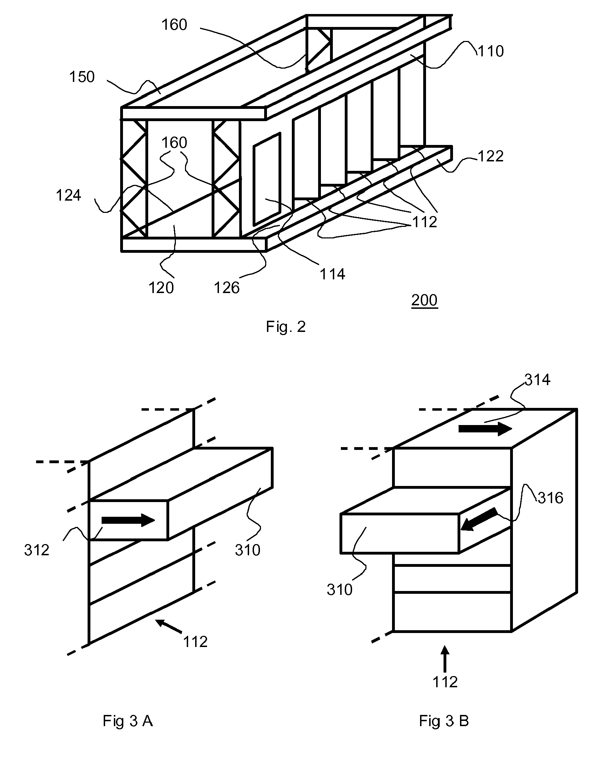

Figure 2 discloses a schematic view of a modular datacenter housing unit 200 as a further embodiment of the modular datacenter element according to the invention. The modular datacenter housing unit 100 comprises a front wall 110, a bottom panel 120, a top frame 150 and a plurality of support elements 160. The front wall 110 is placed away from a first edge 122 of the bottom panel, thus providing a ledge 126 between the front wall 110 and the first edge 122. The width of the edge 126 is substantially smaller than the total width of the bottom panel 120.

The top frame 150 is supported by the support elements 160. In the embodiment shown by Figure 2, the top frame 150 is supported by four support elements 160. Two support elements 160 are provided at opposite vertical ends of the front wall 110 and two support elements 160 are provided at opposite ends of a second edge 124 of the bottom panel, which second edge 124 is opposite to the first edge 122. The top frame 150 is provided to facilitate stacking of various modular datacenter housing units with racks or with other elements and/or functionality.

The advantage of providing the support elements 160 is that no rear wall is required for supporting the top frame 150 or a top panel. In addition, the front wall 110 can be provided in a light material rather than a heavy material making the front wall 110 suitable for supporting either the top frame 150 or a top panel. A person skilled in the art will thus also understand that the rear wall 130 as shown by Figure 1A and Figure 1B and the front wall 110 may also have a function similar to that of the support elements 160.

Figure 3A and Figure 3B disclose two embodiments on how equipment can be installed in the racks 112. Figure 3A discloses a rack 112 in which equipment like a server 310 is placed with front and back side parallel to the front wall 110. In this way, the front side and back side of the server 310 can be instantly monitored and inspected without any further handling, as both the front side and the backside are readily visibly from either side of the front wall 110 (Figure 1 A). Furthermore, in case the server 310 needs to be taken out of the rack 112 for replacement or servicing, the server 310 can be taken directly taken out of the rack 112, without further handling of the rack 112. This can be done by sliding the server 310 out of the rack 112 in the direction of the arrow 312.

Figure 3B discloses a rack 112 having a different configuration than shown by Figure 3A. In the embodiment shown by Figure 3B, the front side of the rack is located perpendicular to the alignment of the plurality of racks 112. As the width of a 19 inch rack is smaller than the usual length (either 31.5 inches (800 mm) or 39.4 inches (1,000 mm)), this embodiment is practical in case mobile data center housing units are used with relatively small dimensions. A disadvantage is that before taking out a server 310 from the rack 112 in the direction of the arrow 316, or even before properly inspecting the front side of the server 310, the rack 112 requires to be taken out from a line of racks in the direction of another arrow 314 first.

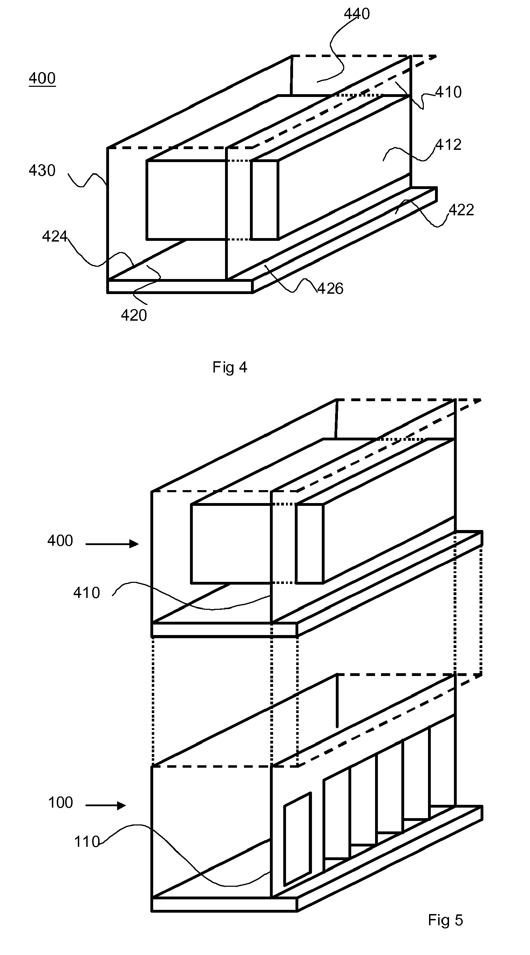

Figure 4 shows a schematic view of a modular cooling housing unit 400 as an embodiment of the modular datacenter cooling element according to the invention. The modular cooling housing unit 400 comprises a front wall 410, a bottom panel 420 and a rear wall 430. The front wall 410 is placed away from a first edge 422 of the bottom panel, thus providing a ledge 426 between the front wall 410 and the first edge 422. The width of the edge is substantially smaller than the total width of the bottom panel 420. The rear wall 430 has about the same dimensions as the front wall 410 and is placed substantially parallel to the front wall 410 at or close to a second edge 424 of the bottom panel, which second edge 424 is opposite to the first edge 422.

The actual dimensions of the modular cooling housing unit 400 are substantially defined by the size of the height and width of the front wall 410 and the depth and width of the bottom panel 420. Because the rear wall 430 has about the same dimensions as the front wall 410 and is placed substantially parallel to the front wall 410 at or close to a second edge 424 of the bottom panel, dimensions of the rear wall 430 do not provide additional information on the definition of the dimensions of the modular cooling housing unit 400. Also an optional top panel 440 would not substantially change the dimensions of the modular cooling housing unit 400, other than possibly by a certain thickness of the top panel 440. The top panel 440 is drawn with a dotted line for reasons of clarity. The modular cooling housing unit 400 further comprises a cooling unit 412 provided in a large opening in the front wall 410.

Though the cooling unit 412 is specifically described here as an element for cooling, the cooling unit 412 can as an air handling unit also provide other types of air handling alternatively or additionally to cooling. Examples are filtering and humidification and other handling options can be envisaged as well.

Alternatively, the rear wall 430 and the top panel 440 are omitted and the modular cooling housing unit 400 is provided with a top frame and support elements similar to the top frame 150 and support elements as shown in Figure 2.

The modular cooling housing unit 400 is intended to be used in conjunction with an embodiment of the modular datacenter element according to the invention and/or embodiments thereof as shown in Figure 1A, Figure 1B and Figure 2. Figure 5 shows a modular datacenter housing unit 100 and a modular cooling housing unit 400. The modular cooling housing unit 400 is intended to be placed on top of the modular datacenter housing unit 100 as indicated by the vertical dotted lines in Figure 5.

In particular, the front wall 410 of the modular cooling housing unit 400 should be aligned with the front wall 110 of the modular datacenter housing unit 100. The objective of this alignment is to create a continuous wall to separate warm air on one side of the continuous wall from cold or at least colder air on another side of the continuous wall formed by the front wall 410 of the modular cooling housing unit 400 and the front wall 110 of the modular datacenter housing unit 100.

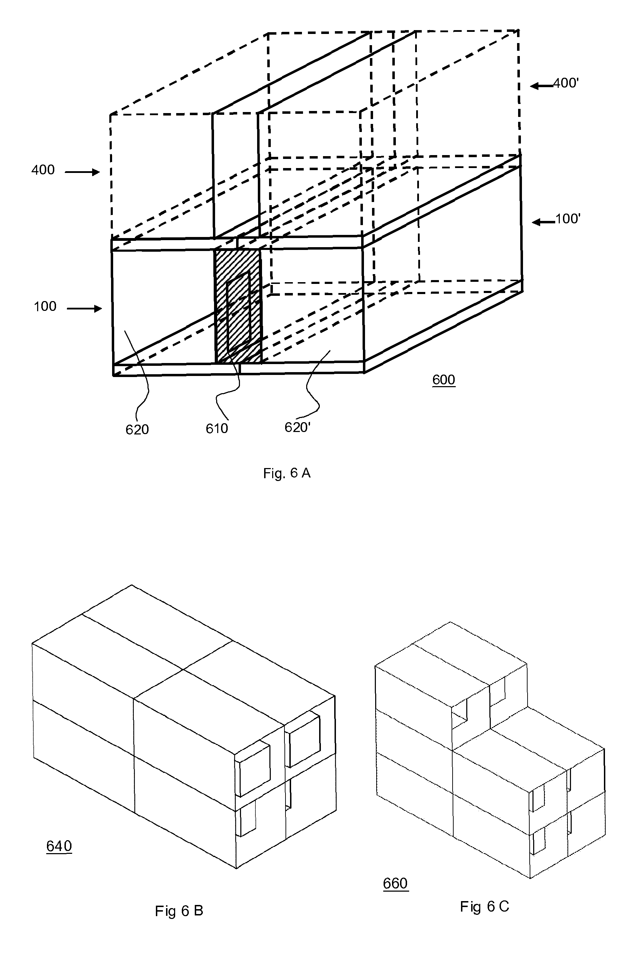

The working principle of the cooling by the modular cooling housing unit 400 and the cooling unit 412 will be described by means of a larger combination of two modular datacenter housing units and two modular cooling housing units. Figure 6A shows a combination of a first modular datacenter housing unit 100, a second modular datacenter housing unit 100', a first modular cooling housing unit 400 and a second modular cooling housing unit 400'. The second modular datacenter housing unit 100' is either a mirrored version of the first modular datacenter housing unit 100 or similar to datacenter housing unit 100, but turned over 180°. The same possible relations apply to the first modular cooling housing unit 400 and the second modular cooling housing unit 400'. The combination of the first modular datacenter housing unit 100, the second modular datacenter housing unit 100', the first modular cooling housing unit 400 and the second modular cooling housing unit 400' constitutes a datacenter 600 as an embodiment of the system according to the invention.

The two front walls and the two lines of racks of the first modular datacenter housing unit 100 and the second modular datacenter housing unit 100' are separated by two ledges of the first modular datacenter housing unit 100 and the second modular datacenter housing unit 100', thus creating a corridor between aligned racks comprised by the first modular datacenter housing unit 100 and the second modular datacenter housing unit 100'. Optionally, the corridor can be closed at the perimeter of the datacenter 600 by means of a door 610.

Additionally or alternatively, a first sidewall 620 and a second sidewall 620' can be provided over the width of the first modular datacenter housing unit 100 and the second modular datacenter housing unit 100', in line with the door 610 for closing the datacenter 600. In this way, with a front wall, sidewalls and a rear wall, a modular datacenter housing unit can be fully closed, being only accessible by means of the door 114 (Figure 1 A). In this way, access to the modular datacenter housing unit can be restricted on a need-to-be basis.

The configuration shown by Figure 6A can be extended with a similar module, providing another larger datacenter 640 as shown by Figure 6B. The dimensions of the other datacenter 640 are twice as large as those of the datacenter housing unit 100 (Figure 1). The other datacenter 640 preferably is approximately six meters wide, six meters high and twelve meters long, with a corridor of 12 meters on the ground floor.

Alternatively, two modular datacenter housing units can be stacked on top of each other and be topped with a modular cooling housing unit, constituting a further larger datacenter 660 as shown in Figure 6C. These configurations can be extended by adding individual housing units for cooling or holding racks or by adding larger combinations as shown by Figure 6B and/or Figure 6C.

A datacenter thus constructed can be placed in a building for improved shielding against pollution, extreme weather conditions and unwanted attention from for example criminals. Alternatively, when restrictions are less tight, the datacenter is directly built in open air. It will be apparent that in such cases, the units directly adjacent to the outside of the datacenter will be provided with walls. These walls may be standard walls or walls with extra protection like anti-theft and/or anti-vandalism features and/or with extra isolation to provide protection against extreme weather conditions.

Besides units holding racks for regular data equipment and cooling, datacenters also require support equipment and other support modules. Examples of such support equipment and/or functionality are UPS (uninterruptible power supply), mainboards, Diesel generators, switching gear, a meetme-room - intended for interconnection of cabling and for housing of telecom operators - a loading bay, a security lodge, a canteen, a power module, storage, fire extinguishing equipment, offices, a canteen and a board room. It will be apparent that this list of examples is provided merely to illustrate embodiments of the invention, rather than to provide an exhaustive list.

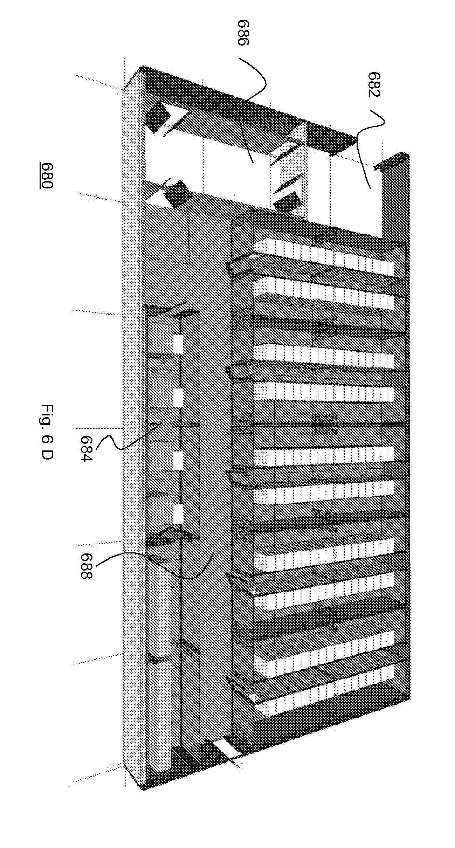

Figure 6D shows a lower level of a larger datacenter 680. The lower level of the larger datacenter 680 comprises multiple modular datacenter housing units, 20 units in this case, a loading bay 682, a power module 684 comprising mainboard, UPS, standby generator, an additional room 686 that may be used as office, security lodge, canteen and/or storage and a hallway 688 connecting the various modules of the larger datacenter 680.

On top of the multiple modular datacenter housing units, either an additional layer of multiple modular datacenter housing units or a layer with modular cooling housing units may be placed. On top of the other elements, like the loading bay 682, other modules like a canteen may be placed.

A person skilled in art will readily understand that with various types of modules provided, numerous, if not countless, configurations of datacenters are possible without departing from the scope of the invention.

By virtue of its modular nature, such fully equipped datacenters can start small and be expanded along the need for data handling capacity. In this way, capital expenditure is spread over a longer time, because not all equipment required for a very large datacenter will have to be installed from day one onward. Instead, the total load of support equipment like fire extinguishers will be increased over time by adding modules providing that functionality.

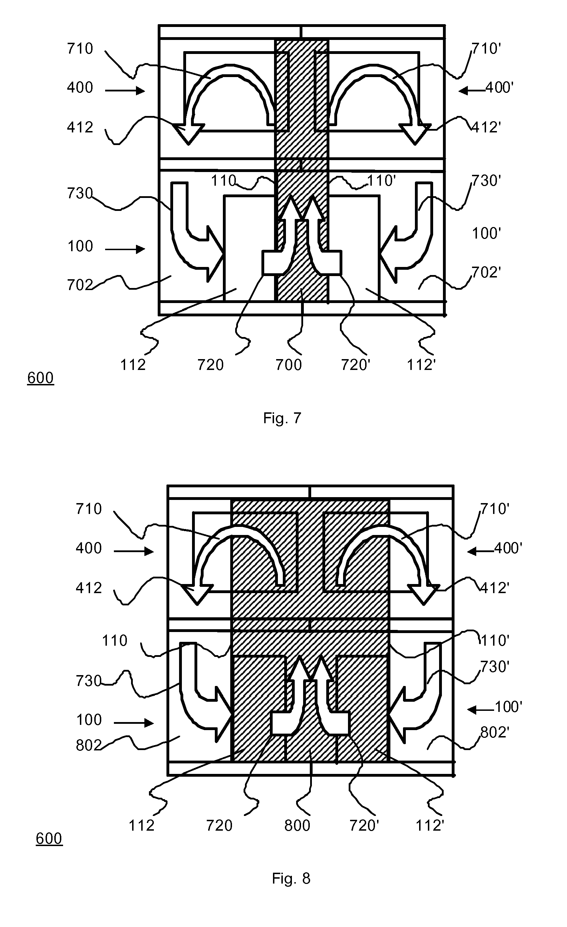

Figure 7 shows a cross-section of the datacenter 600. In the datacenter 600, a hot zone 700 indicated by a hashed area is provided between two front walls of two modular datacenter housing units and two modular cooling housing units. The hot zone 700 coincides with the corridor between the two front walls of the first modular datacenter housing unit 100 and the second modular datacenter housing unit 100' and a further corridor between the two front walls of the first modular cooling housing unit 400 and the second modular cooling housing unit 400'.

An airflow is created by a first cooling unit 412 and a second cooling unit 412'. At the first cooling unit 412, air is taken in at the right side of the first cooling unit 412, cooled and subsequently exhausted at the left side of the first cooling unit 412 as indicated by an arrow 710. Air does not necessarily have to be taken in at the actual sidewalls or front walls of the first cooling unit 412, but this is also possible at respective sides at the bottom or the top of the first cooling unit 412.

Cooled air exhausted subsequently flows to the first modular datacenter housing unit 100, as indicated by a further arrow 730, to a first cool zone 702. Either passively by means of the airflow or actively by means of operating fans in equipment located in racks 112 in the first modular datacenter housing unit 100, air is led through the equipment to the right side of the front wall 110. With the air flowing through the equipment, the equipment exchanges heat with the air, resulting in the air heating up and the equipment cooling down. The heated air flow subsequently flows via a hot zone 700 to the first cooling unit 412 as indicated by another arrow 720.

The preferred temperature of the first cold zone 702 and the second cold zone 702' is 24°C +/- 5°C and the preferred temperature of the hot zone 700 is 34°C +/- 5°C. With an average power load of 5kW per rack and a maximum power load of 25kW per rack and a preferred eight racks per modular datacenter housing unit, the total cooling load is preferably between 160 kW and 320 kW. An important factor for the total cooling load is whether a datacenter comprises one or two stories of modular datacenter housing units. A two-story design requires higher cooling capacity, because two layers require to be cooled by one and the same cooling or air-handling layer. In the racks, locations not holding equipment are shielded or closed to prevent that air flows through those locations, because such air flow would not cool equipment. By providing shielding in those locations, all cool air is force to flow through equipment.

At the right side of the datacenter 600, the same process takes place by an airflow in a mirrored way, with the same elements as on the left side. Mirrored elements are indicated by the same reference numerals and marked with an accent.

An important advantage of the hot zone 700 being shared by the first modular datacenter housing unit 100 the first modular cooling housing unit 400 is that redundancy is provided in cooling air. If either the first cooling unit 412 or the second cooling unit 412' fails, cooling for the full datacenter 600 is taken over by the non-failing cooling unit. In the following description, it assumed that the second cooling unit 412' fails. The first cooling unit 412 draws hot air from the hot zone 700. As no cool air is led to the second cool zone 702', an underpressure is created in the second cool zone 702'. This issue may be addressed by providing an underpressure valve in the second cool zone 702'. This underpressure valve may connect the second cool zone 702' to the first cool zone 702 for providing cool air to the second cool zone 702' or to the environment outside the datacenter 600, either directly or via a filter. Reciprocally, an overpressure valve may be provided in the first cool zone 702, in connection with for example the second cool zone 702' for providing cool air to the second cool zone 702' or to the environment outside the datacenter 600, either directly or via a filter.

Just as the hot zone 700 is shared by multiple housing units (datacenter housing units as well as cooling housing units), the first cool zone 702 and the second cool zone 702' can be shared with neighboring housing units as well, thus creating additional redundancy for cooling. This embodiment can be implemented by the modular datacenter housing unit 100 as shown by Figure 1 by providing pass-through holes, valves, vents or elements having equivalent functionality in the rear wall 103 (Figure 1) or by the modular datacenter housing unit 100 as shown by Figure 2, which has no rear wall.

In particular in the case where the first cool zone 702 is shared with an adjacent datacenter housing unit without a wall in between the two datacenter housing units, the distance between the racks of both datacenter housing units may be smaller than discussed previously. Referring to Figure 1B, the distance between the racks 112 and the second edge 124 may be half the size of the dimension of the racks measured along the width of the bottom panel 120. Together with the space between a further second edge of the adjacent datacenter housing unit, the total available space for taking out a server from one of the racks 112 amount up to the total size of the dimension of the racks measured along the width of the bottom panel 120, which is sufficient for properly handling equipment.

Here, it should be noted that the rear wall 103 in the modular datacenter housing unit 100 as shown by Figure 1 is not only provided to support the top panel 104, but also for providing security by shielding off an area that should only be accessible by authorized personal.

Figure 8 shows a datacenter 600 with the same elements as discussed by means of and as shown by Figure 7. The difference between the datacenter 600 shown by Figure 8 and the datacenter 600 shown by Figure 7 is that in Figure 8, another hot zone 800 is provided that is significantly larger than the hot zone 700 shown by Figure 7. The other hot zone 800 is established by moving the front wall 110 of the first modular datacenter housing unit 100 and the front wall 110' of the second modular datacenter housing unit 100' away from each other. It is noted that this is done while leaving the racks 112 at their locations, so equipment can still be taken out of the racks using space available in a first cool zone 802 or a second cool zone 802'. It is noted that also the sidewall 410 of first modular cooling housing unit 400 and the front wall 410' of the second modular cooling housing unit 400 are spaced away further away than shown in Figure 7. Though the front walls have another locations, the airflows within the datacenter 600 remain substantially unchanged compared to those in Figure 7..

In addition to the embodiments shown by Figure 7 and figure 8, other variations are possible. The front wall or front walls of the first modular datacenter housing unit 100 and the second modular datacenter housing unit 100' do not necessarily have to be aligned with the front wall or front walls of the first modular cooling housing unit 400 and the second modular cooling housing unit 400'. It is more important that the cool zones are well separated from the hot zones by a barrier. The reason for this is that in this way, the air can be cooled more efficiently, as well as the equipment as compared to a case where hot air coming out of equipment is mixed with cool air exhausted by the cooling unit 412. For safety reasons, valves, vents or similar devices may be provided in the barrier.

In the embodiment as shown by Figure 7 and Figure 8, it will be apparent to a person skilled in the art that the boundaries between the modular datacenter housing units and the modular cooling housing units have arrangements in them to enable air to flow through. This can be arranged by providing no floor at all in which case the bottom panel is only provided by e.g. a frame, by providing a floor with grating or holes in it, by providing a floor with a smaller width, by providing a floor with valves or vents or by similar ways. Optionally, the pass-through openings in the floor - if any - may be provided with fans.

Though in the embodiment discussed above, the hot zone is provided in a space delimited by front walls and ledges of adjacent modular datacenter housing units and cool zones are provided on the other sides of the front walls, the locations of hot and cold zones may be swapped by reversing the airflows in the air handling units. Preferably, the underpressure valves and the overpressure valves are swapped as well.

Referring back to Figure 4, the cooling unit 412 can be embodied in various ways. A currently commonly used air cooling method is closed-loop vapor-compression cooling, which is used in conventional air conditioning units.

Alternatively, the cooling may be established by means of evaporative cooling. With evaporative cooling, air is cooled by letting water or another liquid evaporate in the air. This has a cooling effect as thermal energy in the air is used to evaporate the liquid.

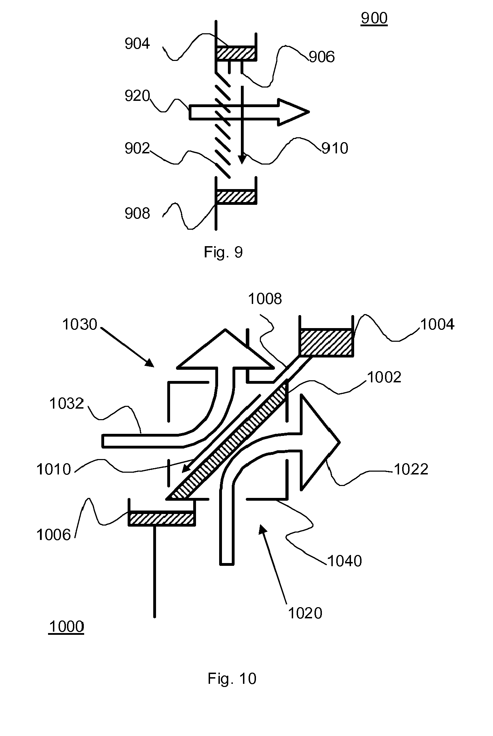

Figure 9 shows a direct evaporative cooler 900, comprising a vent 902, a first reservoir 904, a conduit 906 and a second reservoir 908. The datacenter environment is located on the right side of Figure 9. Via the conduit 906, water - or another liquid - is led from the first reservoir 904 over the vent 902 in the direction of the arrow 910 to the second reservoir 908. Through the vent 902, an airflow 920 is led, in which the water led over the vent 902 evaporates. The airflow 920 may be assisted by a fan (not shown) or a natural airflow as a result of wind - or both. As a result of the evaporation, the air in the airflow 920 cools down. The water recuperated in the second reservoir 908 can be led back to the first reservoir 906 by means of a pump to be re-used again.

An advantage of this cooling method is that it is cheap from a perspective of bill of materials, but also from a perspective of energy consumption. In particular on a relatively cold day, where no (additional) cooling of outside air is required to meet cooling requirements of a datacenter, even no evaporation is required, meaning the only energy required is energy to operate a fan. Furthermore, as the direct evaporative cooler 900 has only a very limited number of parts, the direct evaporative cooler 900 has a high reliability, in particular compared to conventional expansion-based air conditioning units. Additionally, air flowing into the datacenter is humidified by the water evaporated in the air. This reduces the risk on electrostatic discharges within the datacenter that may harm equipment located in the datacenter.

A disadvantage of the direct evaporative cooler 900 is that outside air is led into the datacenter, which poses a serious threat to the equipment located in the datacenter in case the outside air is seriously polluted. This is in particular the case if for example a nearby building is on fire, but also if the datacenter is located near heavy industry. For the same reason, preferably purified water is used for the water led over the vent 910.

Figure 10 shows an indirect evaporative cooler 1000, comprising a heat exchanger 1002, a first reservoir 1004, a second reservoir 1006, a conduit 1008, a primary side 1020 and a secondary side 1030. The datacenter environment is located on the right side of Figure 10. The primary side 1020 and the secondary side 1030 are provided in a housing 1040. Water - or another liquid - is led from the first reservoir 1004 via the conduit 1008 over the heat exchanger 1002 at the secondary side 1030 in the direction of the arrow 1010 towards the second reservoir 1006.

At the secondary side 1030, a secondary airflow 1032 is led over the wetted heat exchanger 1002, resulting of water to evaporate. The water recuperated in the second reservoir 1006 can be led back to the first reservoir 1004to be re-used again. As a result of the evaporation of the water, the heat exchanger 1002 is cooled. At the primary side 1030, a primary airflow 1022 is led along the heat exchanger 1002. As the heat exchanger 1002 is cooled off due to the evaporation of water, the primary airflow 1022 is cooled off as well. The heat exchanger 1002 is preferably manufactured from polypropylene, and other materials or a mix thereof, possibly with polypropylene, can be envisaged as well.

The water recuperated in the second reservoir 1006 can be led back to the first reservoir 1004 by means of a pump to be re-used again. In addition, some of the water evaporated in the secondary airflow 1032 may condensate again in the housing 1040. This water is subsequently led back to the second reservoir 1006 and subsequently to the first reservoir by means of the pump. The secondary airflow 1032 and the primary airflow 1022 may be generated by means of fans. Those fans can be located close to or in the indirect evaporative cooler, but may also be placed further away. Alternatively or additionally, the secondary airflow 1032 may exist naturally by virtue of the wind.

An advantage of the indirect evaporative cooler 1000 is that other than the temperature, the characteristics of the air are not changed by the indirect evaporative cooler 1000. This holds for example for the humidity and the pollution level. As to humidity, a disadvantage is that when the air in the datacenter is relatively dry, the air may have to be humidified to reduce the risk of electrostatic discharge.

The general advantage of evaporative cooling over closed-loop vapor-compression cooling (or refrigeration) is that evaporative cooling is less expensive and more reliable. Evaporative cooling is less expensive in initial capital expenditure because the equipment is less expensive. In addition, evaporative cooling is more energy efficient in use. This results in less expenditure on energy cost, but also in less infrastructure to be laid down in terms of power cables. A further advantage is that with less energy consumption, air handling units may be placed in a power circuit powered by UPS, without substantial penalties to the time period in which the UPS provides back-up power. Evaporative cooling is more reliable than closed-loop vapor-compression cooling as it comprises less moving parts.

An evaporative cooler like the direct evaporative cooler 900 or the indirect evaporative cooler 1000 can be combined with a DX (direct expansion) cooling unit. This is particularly preferred when a climate dictates the extra cooling power, such as hot and humid environments.

Expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

In the description above, it will be understood that when an element such as layer, region, substrate or other element is referred to as being on or onto another element, the element is either directly on the other element, or intervening elements may also be present.

Furthermore, the invention may also be embodied with less components than provided in the embodiments described here, wherein one component carries out multiple functions. Just as well may the invention be embodied using more elements than depicted in the various Figures, wherein functions carried out by one component in the embodiment provided are distributed over multiple components.

A person skilled in the art will readily appreciate that various parameters disclosed in the description may be modified and that various embodiments disclosed and/or claimed may be combined without departing from the scope of the invention.

It is stipulated that the reference signs in the claims do not limit the scope of the claims, but are merely inserted to enhance the legibility of the claims.

## Claims

1. Modular datacenter element, comprising:
a) A modular space defined by at least
i) a bottom panel; and
ii) a front wall having substantially the same length as the bottom panel, placed substantially vertically on the bottom panel;
b) a plurality of racks for holding equipment, the racks being aligned in an opening in the front wall along the length of the bottom panel;
wherein a first side of the aligned plurality of racks is spaced away from a first edge along the length of the bottom panel at a distance substantially smaller than the width of the bottom panel, thus creating a ledge bottom part between the first edge of the bottom panel and the plurality of racks.

2. Modular datacenter element according to claim 1, wherein a second side of the aligned plurality of racks opposite to the first side of the racks is spaced away from a second edge of the bottom panel opposite to the first edge of the bottom panel at a pre-determined distance determined by a dimension of the racks along the width of the bottom panel.

3. Modular datacenter element according to claim 2, wherein the pre-determined distance determined by the dimension of the racks is at least the same as a dimension of a rack along the width of the bottom panel.

4. Modular datacenter element according to claim 1, further comprising a rear wall having substantially the same dimensions as the front wall and being located at or close to the second edge of the bottom panel, substantially parallel to the front wall

5. Modular datacenter element according to claim 1, further comprising
a) at least two support elements near or at opposite ends of the second edge of the bottom panel; and
b) a top frame located at the upper side of the modular datacenter element, the top frame comprising four side elements, each element being parallel to an edge of the bottom panel, the top frame being support by at least the two support elements.

6. Modular datacenter element according to claim 1, wherein the racks are aligned perpendicular to the front wall

7. Modular datacenter element according to claim 1, wherein the racks are aligned parallel to the front wall and the racks are placed on a slidable mount ranging from the front wall towards the rear wall.

8. Modular datacenter element according to claim 1, further comprising a door in the front wall.

9. Modular datacenter element according to claim 1, further comprising a top panel having substantially the same size as the bottom panel and being located on top of the front wall and the rear wall, substantially parallel to the bottom panel.

10. Modular datacenter air handling element, comprising:
a) an air handling unit;
b) a further bottom panel having substantially the same dimensions as the bottom panel of the modular datacenter element according to claim 1;
c) a wall holding the air handling unit for separating hot air to be cooled from cool air flowing out of the air handling unit;
wherein
d) the modular datacenter air handling element is arranged to be placed either on top of or below the modular datacenter element according to claim 1, whereby when the modular datacenter air handling element is placed on top of or below the modular datacenter element, the front wall of the modular datacenter cooling element forms together with the front wall of the modular datacenter element a contiguous substantially vertical barrier in the ensemble of the modular datacenter air handling element and the modular datacenter element;
e) the air handling unit is arranged for generating and cooling an airflow flowing from a first side of the air handling unit to a first side of the front wall of the modular datacenter element, through at least a part of the plurality of racks towards a second side of the front wall and to a second side of the air handling unit; and
f) the further bottom panel is arranged for passing trough the airflow.

11. Modular datacenter air handling element as claimed in claim 10, wherein the air handling unit comprises an evaporative cooling unit.

12. System comprising:
a) At least two modular datacenter elements according to claim 1, arranged such that the front walls of two modular datacenter elements are substantially parallel to one another and facing each other with the ledges meeting each other; and
b) At least two modular datacenter air handling elements according to claim 9, each modular datacenter air handling element placed on top of a modular datacenter element, such the front wall of the modular datacenter air handling element forms together with the front wall of the modular datacenter element a contiguous substantially vertical barrier in the ensemble of the modular datacenter air handling element and the modular datacenter element.

13. System as claimed in claim 12, wherein a door is placed between and perpendicular to a first front wall of a first modular datacenter element and a second front wall of a second modular datacenter element providing access to a corridor formed by the first front wall, the second front wall and a first ledge bottom part of the first modular datacenter element and a second ledge bottom part of the second modular datacenter element.
